# EUROPÄISCHE PATENTSCHRIFT

(11) **EP 4 193 426 B1**
(45) Veröffentlichungstag und Bekanntmachung des Hinweises auf die Patenterteilung: **16.07.2025**
(21) Anmeldenummer: 21766676.7
(22) Anmeldetag: 30.08.2021
(51) Int. Cl.: H01M 10/42, H01R 11/12, H01M 10/48, H01R 4/30, H01M 50/204, H01M 50/296, H01M 50/505, H01M 50/569, H01M 50/517, G01R 27/14, H02G 15/113, H02G 15/115

(54) **ELEKTROVERBINDUNG, ISOLIERGEHÄUSE FÜR EINE SOLCHE, VERFAHREN UND WERKZEUG FÜR EIN SOLCHES**
ELECTRICAL CONNECTION, INSULATING HOUSING FOR SUCH, METHOD AND TOOL FOR SUCH
RACCORDEMENT ELECTRIQUE, BOITIER ISOLANT POUR UN TEL RACCORDEMENT, PROCEDE ET OUTIL POUR UN TEL RACCORDEMENT

(30) Priorität: 21.10.2020 DE 102020213296
(43) Veröffentlichungstag der Anmeldung: 14.06.2023
(73) Patentinhaber: LEONI Bordnetz-Systeme GmbH, 97318 Kitzingen (DE)
(72) Erfinder: ALBERT, Volker, 97337 Dettelbach (DE); RÖDER, Manuel, 97236 Randersacker (DE); VORNBERGER, Eginhard, 97320 Buchbrunn (DE)
(74) Vertreter: FDST Patentanwälte
(86) Internationale Anmeldenummer: PCT/EP2021/073838
(87) Internationale Veröffentlichungsnummer: WO 2022/083925

(56) Entgegenhaltungen:
- EP-B1- 2 755 849
- CN-A- 103 930 304
- DE-A1- 3 518 626
- OBERG A ET AL: "SHAPE MEMORY ALLOYS FOR POWER CONNECTOR APPLICATIONS", PROCEEDINGS OF THE HOLM CONFERENCE ON ELECTRICAL CONTACTS. PITTSBURGH, SEPT. 27 - 29, 1993; [PROCEEDINGS OF THE HOLM CONFERENCE ON ELECTRICAL CONTACTS], NEW YORK, IEEE, US, vol. CONF. 39, 27 September 1993 (1993-09-27), pages 225 - 228, XP000419874

## Beschreibung

Die Erfindung betrifft eine Elektroverbindung sowie ein Isoliergehäuse für eine solche Elektroverbindung. Weiterhin betrifft die Erfindung ein Verfahren im Zusammenhang mit einer Elektroverbindung sowie ein Werkzeug für ein solches Verfahren.

Eine Elektroverbindung weist allgemein zwei Kontaktteile auf, welche elektrisch leitend miteinander verbunden sind. Dabei sind die beiden Kontaktteile direkt und unmittelbar miteinander verbunden, sodass ein Strom von einem zum anderen Kontaktteil fließen kann. Zur Fixierung der beiden Kontaktteile relativ zueinander können diese mittels eines Verbindungselements miteinander verbunden werden. Elektroverbindungen finden beispielsweise Verwendung im Automobilbereich, beispielsweise bei der Anbindung eines Modulverbinders in einer Hochvoltbatterie. Die Hochvoltbatterie weist mehrere Module auf, deren Terminal paarweise mit einem Modulverbinder verbunden werden, um die Module elektrisch miteinander zu verschalten.

Ein Beispiel für eine Elektroverbindung ist eine Elektro-Schraubverbindung, bei welcher zwei Kontaktteile mittels einer Schraube miteinander verschraubt sind. Die beiden Kontaktteile sind beispielsweise nach der sogenannten Verschraubklasse A, auch Kategorie A, gemäß VDI-Richtlinie 2862 miteinander verschraubt. Bei der Montage der Elektroverbindung werden die beiden Kontaktteile miteinander verschraubt und dabei ein definiertes Montagemoment auf die Schraube aufgebracht. Zugleich wird der Drehwinkel der Schraube überwacht. Das Montagemoment dient hier als Steuergröße, der Drehwinkel als Kontrollgröße. Soweit das Montagemoment und der Drehwinkel innerhalb eines vorgegebenen Toleranzfensters liegen, wird die Verschraubung als korrekt klassifiziert, d. h. als fehlerfrei angenommen.

Eine gute Elektroverbindung zeichnet sich aber vor allem durch einen möglichst geringen Übergangswiderstand zwischen den beiden Kontaktteilen aus. Speziell bei Elektroverbindungen, durch welche ja ein Strom fließen soll, soll der Übergangswiderstand möglichst gering sein, um im Betrieb die Verlustleistung und eine damit einhergehende Erwärmung der Elektroverbindung möglichst gering zu halten. Der Übergangswiderstand hängt typischerweise hauptsächlich von einer Vorspannkraft (auch als Kontaktnormalkraft bezeichnet) ab, mit welcher die beiden Kontaktteile beim Verbinden aneinandergedrückt werden. Wird beispielsweise beim oben beschriebenen Verschrauben eine unzureichende Vorspannkraft verwendet, dann wird der geforderte, geringe Übergangswiderstand unter Umständen nicht erreicht. Im Betrieb kann sich die Elektroverbindung dann erwärmen oder sogar einen Brand verursachen, was Schäden an der Elektroverbindung selbst und auch an anderen Bauteilen zur Folge haben kann.

Die beim Verschrauben verwendeten Größen, d. h. das Montagemoment und der Drehwinkel, sind hinsichtlich des Übergangswiderstands lediglich indirekte Größen und lassen daher einen nur unzureichenden Schluss auf den Übergangswiderstand nach der Montage zu. Ob die Verschraubung für die vorgesehene elektrische Verwendung korrekt ist, kann nicht unbedingt sicher beurteilt werden. Beispielsweise können das Montagemoment und der Drehwinkel zwar im geforderten Toleranzfenster liegen, dennoch kann sich bei einem zu hohen Reibwert von möglicherweise fehlerhaften Kontaktteilen oder einer fehlerhaften Schraube eine unzureichende Vorspannkraft ergeben. Auch ist denkbar, dass sich die Schraube kurz vor Erreichen von deren Endposition verkantet und dann der Schraubenkopf nicht oder nicht vollständig aufliegt, sodass ebenfalls eine unzureichende Vorspannkraft erzielt wird.

Speziell für den oben genannten Anwendungsfall im Zusammenhang mit einer Hochvoltbatterie, aber auch allgemein, ist ein möglichst geringer Übergangswiderstand wünschenswert.

In der WO 2015/185456 A1 ist eine Vierpunkt-Messung als eine Messtechnik für eine Widerstandsmessung beschrieben. Weiterhin wird verwiesen auf EP 2 755 849 B1, DE 35 18 626 A1 sowie Öberg et al., "Shape Memory Alloys for Power Connector Applications" Proceedings of the 39th IEEE Holm Conference on Electrical Contacts, 1993, Seiten 225-228.

Vor diesem Hintergrund ist es eine Aufgabe der Erfindung, bei einer Elektroverbindung einen möglichst sicheren Rückschluss auf deren Übergangswiderstand zu ermöglichen. Insbesondere soll auch ein möglichst geringer Übergangswiderstand sichergestellt werden. Hierzu sollen eine verbesserte Elektroverbindung sowie ein verbessertes Isoliergehäuse für eine solche angegeben werden. Außerdem sollen ein verbessertes Verfahren und ein verbessertes Werkzeug für ein solches Verfahren angegeben werden.

Die Aufgabe wird erfindungsgemäß gelöst durch eine Elektroverbindung mit den Merkmalen gemäß Anspruch 1, durch ein Isoliergehäuse mit den Merkmalen gemäß Anspruch 11, durch ein Verfahren mit den Merkmalen gemäß Anspruch 12 sowie durch ein Werkzeug mit den Merkmalen gemäß Anspruch 14. Vorteilhafte Ausgestaltungen, Weiterbildungen und Varianten sind Gegenstand der Unteransprüche. Die Ausführungen im Zusammenhang mit der Elektroverbindung gelten analog auch für das Isoliergehäuse, das Verfahren und das Werkzeug sowie umgekehrt.

Die Elektroverbindung weist mindestens zwei Kontaktteile, ein Isoliergehäuse und ein Verbindungselement auf. Die beiden Kontaktteile sind mittels des Verbindungselements miteinander verbunden, insbesondere derart, dass die beiden Kontaktteile aneinander anliegen. Vorzugsweise sind die Kontaktteile mittels des Verbindungselements aneinandergedrückt. Das Isoliergehäuse weist ein oder mehrere Durchgangslöcher auf, zum Aufnehmen von Messelektroden zur Bestimmung eines Übergangswiderstands zwischen den beiden Kontaktteilen. Mit anderen Worten: ein jeweiliges Durchgangsloch dient dazu, durch dieses ein oder mehrere Messelektroden in das Isoliergehäuse einzufahren und insbesondere auch wieder herauszufahren.

Nachfolgend wird ohne Beschränkung der Allgemeinheit davon ausgegangen, dass die Elektroverbindung zwei Kontaktteile aufweist. Die Ausführungen gelten analog für Ausgestaltungen mit mehr als zwei Kontaktteilen, welche dann beispielsweise entsprechend viele Batteriemodule miteinander verbinden. Beispielsweise ist ein erstes Kontaktteil in ein erstes Batteriemodul integriert und mit einem zweiten Kontaktteil von einem zweiten Batteriemodul sowie einem dritten Kontaktteil von einem dritten Batteriemodul verbunden.

Ein jeweiliges Durchgangsloch stellt auf einfache Weise einen Zugang zu einem oder beiden Kontaktteilen dar, nämlich von außen durch das Isoliergehäuse hindurch und hin zum Kontaktteil. Zum Messen werden die Messelektroden in die Durchgangslöcher soweit eingefahren, bis ein elektrischer Kontakt mit einem jeweiligen Kontaktteil hergestellt ist. Daraufhin wird gemessen. Anschließend werden die Messelektroden wieder zurückgefahren und dabei insbesondere auf umgekehrtem Wege aus den Durchgangslöchern und allgemein aus dem Isoliergehäuse herausgezogen. Ein jeweiliges Durchgangsloch wird auch als Öffnung oder Elektrodenöffnung bezeichnet und weist eine Innenwand auf, welche auch als Elektrodenkanal bezeichnet wird und insbesondere als Führungskontur für eine oder mehrere Messelektroden dient. Ein jeweiliges Durchgangsloch dient somit insgesamt als Führungskanal für eine oder mehrere Messelektroden.

Zweckmäßigerweise sind die beiden Kontaktteile über die Durchgangslöcher für die Messelektroden derart zugänglich, dass eine jeweilige Messelektrode durch eines der Durchgangslöcher in das Isoliergehäuse einführbar ist und mit einem der beiden Kontaktteile kontaktierbar ist, um einen Spannungsabfall zwischen den beiden Kontaktteilen zu messen. Somit werden zum Messen wenigsten zwei Messelektroden verwendet, von welchen eine mit dem einen Kontaktteil kontaktiert wird und die andere mit dem anderen Kontaktteil. Die Durchgangslöcher sind entsprechend derart ausgebildet und angeordnet, dass beide Kontaktteile von außen für je mindestens eine Messelektrode zugänglich sind.

Die Kontaktteile sind bei bestimmungsgemäßer Verwendung der Elektroverbindung regelmäßig stromführend und daher aus einem elektrisch leitenden Material hergestellt, beispielsweise aus Kupfer oder aus Aluminium. Vorzugsweise sind die Kontaktteile jeweils als eine Stromschiene ausgebildet, d. h. flach und langgestreckt, und weisen somit jeweils eine Flachseite auf, welche zur Herstellung einer elektrischen Verbindung aneinander anliegen und mittels des Verbindungselements aneinandergedrückt sind. In einer bevorzugten Ausgestaltung verbindet die Elektroverbindung in einer Hochvoltbatterie ein Batteriemodul (allgemein Modul), der Hochvoltbatterie mit einem Modulverbinder der Hochvoltbatterie. Das eine Kontaktteil ist dann ein Teil des Batteriemoduls, das andere Kontaktteil dagegen ein Teil des Modulverbinders. Der Modulverbinder weist vorzugsweise eine elektrische Verbindung auf, beispielsweise ein Kabel, eine Stromschiene und/oder ein Litzenkabel mit einem vorzugsweise kompaktierten Kabelende. Die elektrische Verbindung ist geeigneterweise mit mindestens einem der Kontaktteile stoffschlüssig und niederohmig verbunden. Zur Erreichung einer stoffschlüssigen Verbindung eignen sich jegliche Verfahren zum stoffschlüssigen Fügen, insbesondere ein Schweißverfahren, wie beispielsweise Laserschweißen, Lichtbogenschweißen, Gasschmelzschweißen, Widerstandsschweißen, Kaltpressschweißen, Ultraschallschweißen, Diffusionsschweißen und/oder Reibschweißen. Neben stoffschlüssigen Verbindungsverfahren eigenen sich auch andere hier nicht näher aufgezählte und erläuterte Verbindungstechniken, wie beispielsweise Fügen durch Kraftschluss (Reibschluss) oder Formschluss. In einer Hochvoltbatterie werden über die Elektroverbindung mitunter Ströme bei Spannungen ab 100 V übertragen. Die Erfindung eignet sich aber auch für Niedrigvoltanwendungen, d. h. auch für geringere Ströme und/oder geringere Spannungen.

Das Isoliergehäuse dient nicht notwendigerweise ausschließlich zur Bereitstellung der Durchgangslöcher, sondern vorteilhafterweise auch als Berührschutz, d. h. als physische Barriere gegen ein Berühren der Kontaktteile. Entsprechend überdeckt das Isoliergehäuse wenigstens eines der und vorzugsweise beide Kontaktteile oder umgibt oder umschließt dieses bzw. diese sogar. Beispielsweise ist das Isoliergehäuse auf eines der oder auf beide Kontaktteile aufgesetzt oder eines der oder beide Kontaktteile sind in das Isoliergehäuse eingesetzt oder eingesteckt. Das Isoliergehäuse ist vorzugsweise aus einem elektrisch isolierenden Material hergestellt, z. B. aus einem isolierenden Kunststoff. Das Isoliergehäuse ist beispielsweise als Spritzgussteil hergestellt.

Ein spezieller Ausgangspunkt der Erfindung ist insbesondere die Forderung, ein Isoliergehäuse derart zu verbessern, dass dieses an einer Elektroverbindung und nach deren Montage, d. h. nach einem Verbinden der beiden Kontaktteile, eine Bestimmung eines Übergangswiderstands ermöglicht. Erfindungsgemäß weist das Isoliergehäuse hierzu ein oder mehrere Durchgangslöcher auf, zur Aufnahme mehrerer Messelektroden für die Messung. Die Messung ist insbesondere eine sogenannte Vierpunkt-Messung.

Mittels der Durchgangslöcher ist es nun vorteilhaft möglich, nach dem Verbinden der beiden Kontaktteile den Übergangswiderstand zwischen diesen zu bestimmen. Bei dem Verfahren werden dann bei der Elektroverbindung mehrere Messelektroden in die Durchgangslöcher eingeführt und mit den Kontaktteilen in Kontakt gebracht und anschließend wird mittels der Messelektroden eine Messung durchgeführt, anhand dessen der Übergangswiderstand zwischen den beiden Kontaktteilen bestimmt wird. Der Übergangswiderstand wird insbesondere dadurch bestimmt, dass ein Spannungsabfall beim Übergang von einem Kontaktteil zum anderen Kontaktteil gemessen wird. Genau genommen ist die Messung dann eine Spannungsmessung. Der Spannungsabfall erlaubt einen direkten Rückschluss auf den Übergangswiderstand. Der Übergangswiderstand und auch der Spannungsabfall stellen eine Kontrollgröße dar, welche beispielweise zusätzlich zum eingangs erwähnten Drehwinkel erhoben, d. h. bestimmt, wird und an welcher sich jedenfalls direkt die Qualität der elektrischen Verbindung zwischen den beiden Kontaktteilen beurteilen lässt, sodass insgesamt eine bessere Beurteilung der Elektroverbindung möglich ist.

Ein Vorteil der Erfindung ist somit insbesondere eine verbesserte Prozesssicherheit bei der Montage der Elektroverbindung. Beim oder nach dem Verbinden der Kontaktteile ist eine verbesserte Überprüfung der Verbindung realisiert, da durch die Durchgangslöcher im Isoliergehäuse nun auf einfache Weise der Übergangswiderstand der Elektroverbindung bestimmbar ist, wodurch wiederum eine fehlerhafte Verbindung der Kontaktteile besser erkennbar ist. Zumindest nach der Montage oder zusätzlich auch bereits während der Montage und vor allem aber während der Messung stellt das Isoliergehäuse zugleich einen vorteilhaften Berührschutz dar. Außerdem ergibt sich eine kompakte Bauform für die Elektroverbindung, da durch die Integration der Durchgangslöcher in das Isoliergehäuse keine separaten Kontaktpunkte für die Messelektroden bereitgestellt werden müssen.

Nach der Messung des Spannungsabfalls und der Bestimmung des Übergangswiderstands und nachdem die Messelektroden wieder entfernt worden sind, sind die Durchgangslöcher insbesondere funktionslos. Nach der Montage und während des bestimmungsgemäßen Gebrauchs der Elektroverbindung verbleiben die Durchgangslöcher somit lediglich als charakteristische, visuelle Merkmale des Isoliergehäuses. Die Durchgangslöcher verbleiben insbesondere offen, geeignet ist aber auch eine Ausgestaltung, bei welcher die Durchgangslöcher jeweils mit einem Verschlusselement verschlossen werden. Geeignet ist auch eine Ausgestaltung, bei welcher der Übergangswiderstand z. B. im Rahmen einer Wartung erneut bestimmt wird, wozu dann durch die Durchgangslöcher erneut entsprechende Messelektroden eingefahren werden.

Die Messelektroden sind vorzugsweise als Messpitzen ausgebildet, welche auf eine Oberfläche des jeweiligen Kontaktteils gedrückt werden, um einen möglichst punktförmigen elektrischen Kontakt zum Messen herzustellen.

Vorliegend ist das Isoliergehäuse für eine Vierpunktmessung (auch Vierpunkt-Messung) mit vier Messelektroden ausgebildet, nämlich je zwei Messelektroden pro Kontaktteil. Die Messung ist demnach eine Vierpunktmessung. Bei einer Vierpunktmessung werden vier Messelektroden mit den Kontaktteilen in Kontakt gebracht, je zwei Messelektroden pro Kontaktteil. Über zwei der Messelektroden, auch als Stromführungselektroden bezeichnet, wird ein Strom durch die beiden Kontaktteile geschickt und mit den beiden anderen Messelektroden, auch als Spannungsmesselektroden bezeichnet, wird dann eine Spannungsmessung durchgeführt. Ein jeweiliges Kontaktteil ist also mit einer Stromführungselektrode und einer Spannungsmesselektrode kontaktiert. Auf diese Weise ist eine sogenannte Vierleitermessung realisiert, welche vorteilhafterweise weitgehend unabhängig vom Übergangswiderstand zwischen den Messelektroden und den Kontaktteilen ist.

In einer geeigneten Ausgestaltung werden die Messelektroden in einer Reihe auf die Kontaktteile gebracht, sodass zwei Messelektroden innen liegen und die anderen zwei Messelektroden außen liegen. Bei einer solchen Anordnung der Messelektroden in einer Reihe fließt dann zwischen den äußeren beiden Messelektroden ein Strom und die Spannungsmessung erfolgt mit den inneren beiden Messelektroden. Eine solche Anordnung ist jedoch an sich nicht zwingend, da im vorliegenden Fall der Übergangswiderstand nicht notwendigerweise absolut bestimmt werden muss, sondern eine relative Messung bereits ausreichend ist. Beispielsweise wird der Spannungsabfall an einer korrekt montierten Elektroverbindung, d. h. an einem Prüfling, gemessen und als Referenzwert gespeichert, mit welchem dann der Spannungsabfall, welcher an einer anderen Elektroverbindung gemessen wird, verglichen wird. Der Übergangswiderstand wird dann durch einen Vergleich des Spannungsabfalls und des Referenzwertes relativ zum Prüfling bestimmt. Dies ermöglicht eine beliebige Anordnung der Messelektroden und der Durchgangslöcher, sodass deren Positionierung im Isoliergehäuse zweckmäßigerweise derart gewählt ist, dass sich eine möglichst kompakte Bauform für die Elektroverbindung ergibt.

Zweckmäßigerweise sind die Durchgangslöcher derart positioniert, dass die Messelektroden bei der Messung die Kontaktteile außerhalb eines Überlappbereichs der Kontaktteile kontaktieren. Die beiden Kontaktteile, genauer gesagt eine erste Kontaktfläche des einen Kontaktteils und eine zweite Kontaktfläche des zweiten Kontaktteils, liegen zumindest abschnittsweise aneinander an, um einen elektrischen Kontakt herzustellen. Der Überlappbereich ist dann derjenige Bereich, in welchem die beiden Kontaktteile überlappen und aneinander anliegen, um sich gegenseitig zu berühren, d. h. der Bereich der beiden Kontaktflächen. Um eine möglichst genaue Messung durchzuführen, erfolgt eine Kontaktierung der Messelektroden dann zweckmäßigerweise außerhalb dieses Überlappbereichs. Die Durchgangslöcher zu den verschiedenen Kontaktteilen sind hierzu entsprechend weit voneinander beabstandet. Auch eine Messung innerhalb des Überlappbereichs ist grundsätzlich möglich und geeignet, wesentlich ist insbesondere, dass die Messung über die Kontaktflächen erfolgt, d. h., dass der Spannungsabfall über die Kontaktflächen gemessen wird.

Die Messelektroden sind voneinander um eine Messstrecke beabstandet, welche eine räumliche Entfernung ist. Unabhängig von der konkreten Anordnung der Messelektroden ist die Messstrecke zweckmäßigerweise so gering wie möglich. Je geringer die Messstrecke ist, desto genauer ist das Ergebnis der Messung.

In einer geeigneten Ausgestaltung weist das Isoliergehäuse für jede Messelektrode genau ein Durchgangsloch auf. Bei vier Messelektroden für eine Vierpunktmessung weist das Isoliergehäuse entsprechend vier Durchgangslöcher auf. Vorzugsweise weist ein Durchgangsloch einen Querschnitt auf, welcher einem Querschnitt einer jeweiligen Messelektrode entspricht. Die Messelektroden sind geeigneterweise stabförmig und laufen frontseitig zum Kontaktteil hin spitz zu, sodass sich allgemein ein kreisrunder Querschnitt ergibt. Entsprechend weisen dann zweckmäßigerweise auch die Durchgangslöcher jeweils einen kreisrunden Querschnitt auf, sodass in seitlicher Richtung ein Formschluss realisiert ist, sodass eine optimale Führung der Messelektroden in den Durchgangslöchern erzielt wird.

Die Anzahl der Durchgangslöcher muss aber nicht zwingend der Anzahl der Messelektroden entsprechen, vielmehr sind auch Ausgestaltungen geeignet, bei welchen zumindest ein Durchgangsloch ausgebildet ist, mehrere Messelektroden gleichzeitig aufzunehmen. In einer vorteilhaften Ausgestaltung ist hierzu zumindest ein Durchgangsloch als ein Langloch ausgebildet, zur gleichzeitigen Aufnahme mehrerer Messelektroden, insbesondere nebeneinander. Speziell bei einer Messung, bei welcher mehrere Messelektroden nahe beieinander positioniert sind, z. B. die beiden Messelektroden für einen der beiden Kontaktteile bei einer Vierpunktmessung, ist es zweckmäßig, die ansonsten nahe beieinanderliegenden Durchgangslöcher zu einem einzelnen Durchgangsloch für mehrere Messelektroden zusammenzufassen. Zweckmäßigerweise ist zwischen zwei Messelektroden, welche in dasselbe Durchgangloch eingefahren werden, eine Isolierwand angeordnet, welche vorzugsweise ein Teil eines Werkzeugs ist, welches die Messelektroden aufweist. Grundsätzlich ist auch eine Ausgestaltung denkbar und geeignet, bei welcher ein einzelnes Durchgangsloch mehrere Messelektroden für unterschiedliche Kontaktteile aufnimmt oder bei welcher sogar lediglich ein einzelnes Durchgangsloch sämtliche Messelektroden aufnimmt. Somit ist bereits ein Isoliergehäuse mit nur einem Durchgangsloch möglich, vorliegend wird jedoch ohne Beschränkung der Allgemeinheit von einem Isoliergehäuse mit mehreren Durchgangslöchern ausgegangen.

Wie bereits oben angedeutet, dient das Isoliergehäuse zugleich vorteilhaft als Berührschutz, d. h. um eine Berührung der Kontaktteile zu verhindern. Da die Durchgangslöcher jedoch einen Zugang zu den Kontaktteilen ermöglichen, ist der Berührschutz entsprechend gefährdet. Um weiterhin einen möglichst optimalen Berührschutz zu gewährleisten, ist ein jeweiliges Durchgangsloch vorteilhafterweise derart dimensioniert, dass eine Berührung eines Kontaktteils mit einem menschlichen Finger, z. B. simuliert durch einen genormten Prüffinger, durch das jeweilige Durchgangsloch hindurch verhindert ist. Insbesondere sind die Durchganglöcher hierzu derart dimensioniert, dass ein Schutz gemäß der IP-Schutzklasse IPxxB realisiert ist. Hierzu sind die Durchgangslöcher insbesondere möglichst tief und möglichst schmal ausgebildet. Unter "derart dimensioniert" wird insbesondere verstanden, dass das Durchgangsloch solche Abmessungen, d. h. speziell eine Breite und eine Tiefe, aufweist, dass ein durchschnittlicher menschlicher Finger nicht bis zum Kontaktteil vordringen kann. Zweckmäßigerweise wird nicht nur eine Berührung verhindert, sondern bereits ein Vordringen bis zu einer Luftstrecke und/oder Kriechstrecke, welche angibt, in welchem Abstand zum Kontaktteil noch ein Überschlag vom Kontaktteil aus möglich ist. Dies hängt logischerweise von den elektrischen Gegebenheiten des konkreten Anwendungsfalls ab. Mit größer werdender Spannung ist es grundsätzlich wahrscheinlicher, dass auch ohne direkte Berührung des Kontaktteils und noch im Abstand davon die Gefahr eines elektrischen Schlags besteht. Entsprechend wird dann das Durchgangsloch derart dimensioniert, dass ein Vordringen höchstens bis zu diesem Abstand möglich ist. Besonders bei Hochvoltanwendungen, d. h. Spannungen ab 100 V, ergibt sich dann ein insgesamt tunnelartiger Verlauf des entsprechend lang ausgebildeten Durchgangslochs. Ein solch tunnelartiges Durchgangsloch ist auch vorteilhaft hinsichtlich der Führung der Messelektrode beim Einfahren.

Geeignete Abmessungen für ein Durchgangsloch sind beispielsweise eine Breite im Bereich von 0,5 mm bis 5 mm und eine Tiefe im Bereich von 1 mm bis 20 mm. Die Tiefe wird auch als Kriechstrecke bezeichnet und hängt insbesondere von der maximal anliegenden Spannung ab.

Zweckmäßigerweise weist ein jeweiliges Durchgangsloch außenseitig, d. h. auf einer dem Kontaktteil abgewandten Außenseite des Isoliergehäuses, eine Führungsfase auf, um das Einführen einer Messelektrode zu vereinfachen.

Vorzugsweise werden alle Messelektroden von derselben Seite zugeführt, sodass entsprechend auch sämtlich Durchgangslöcher dann zweckmäßigerweise auf derselben Seite des Isoliergehäuses ausgebildet sind. Alternativ ist aber auch eine beidseitige Anordnung der Messelektroden möglich und geeignet, d.h. zwei Messelektroden werden von unterschiedlichen, vorzugsweise gegenüberliegenden Seiten zugeführt, sodass entsprechend die Durchgangslöcher dann auf unterschiedlichen, vorzugsweise gegenüberliegenden Seiten des Isoliergehäuses ausgebildet sind.

Bevorzugterweise verlaufen die Durchgangslöcher senkrecht zu den Kontaktteilen durch das Isoliergehäuse. Dies erleichtert insbesondere die sichere Kontaktierung der Messelektroden. Alternativ oder zusätzlich verlaufen die Durchgangslöcher parallel zum Verbindungselement durch das Isoliergehäuse. Dies ermöglicht insbesondere ein Betätigen des Verbindungselements und ein Einführen der Messelektroden von derselben Seite und in einem einzelnen Montageschritt.

Vorzugsweise verlaufen alle Durchgangslöcher parallel zueinander durch das Isoliergehäuse. Hierdurch ist es möglich, die Messelektroden auf einfache Weise gemeinsam aus derselben Richtung in das Isoliergehäuse einzufahren.

Zweckmäßigerweise weist das Isoliergehäuse für das Verbindungselement eine Aufnahme auf, in welche das Verbindungselement bei der Montage der Elektroverbindung einsetzbar ist. Die Aufnahme weist eine Wand auf, welche einen Hohlraum umgibt, in welchem das Verbindungselement angeordnet ist. Im montierten Zustand ist das Verbindungselement in die Aufnahme eingesetzt und dadurch insgesamt in das Isoliergehäuse eingesetzt und von diesem vorzugsweise verdeckt oder überdeckt, zumindest teilweise. Die Aufnahme erstreckt sich insbesondere in einer Längsrichtung, vorzugsweise senkrecht zu den Kontaktteilen. Das Verbindungselement erstreckt sich dann ebenfalls in Längsrichtung. Die Aufnahme ist geeigneterweise analog zu den Durchgangslöchern derart dimensioniert, dass eine Berührung eines Kontaktteils mit einem menschlichen Finger, ggf. simuliert durch einen genormten Prüffinger, durch das jeweilige Durchgangsloch hindurch verhindert ist. Die Ausführungen hierzu im Zusammenhang mit den Durchgangslöchern gelten entsprechend auch für die Aufnahme.

Die Aufnahme ist geeigneterweise ringförmig ausgebildet, d. h. weist eine ringförmige Wand auf, welche einen zylinderförmigen Hohlraum umringt, in welchen das Verbindungselement einsetzbar ist und in welchem zumindest in einem montierten Zustand das Verbindungselement eingesetzt ist.

In einer besonders vorteilhaften Ausgestaltung ist die Aufnahme eine Kammer, mit einem Zugangsloch, durch welches ein Werkzeug zur Betätigung des Verbindungselements bei der Montage in die Kammer einführbar ist, nicht aber das Verbindungselement selbst. Im Querschnitt entlang der Längsrichtung betrachtet wird das Verbindungselement dann von dem Isoliergehäuse überdacht. Einerseits ist dadurch das Verbindungselement verliersicher im Isoliergehäuse untergebracht, andererseits ist das Zugangsloch deutlich geringer dimensionierbar als ein Einführloch für das Verbindungselement, sodass ein verbesserter Berührschutz gewährleistet ist. Üblicherweise ist das Verbindungselement nämlich aus einem elektrisch leitenden Material hergestellt und steht in montiertem Zustand mit den Kontaktteilen in Verbindung, sodass das Verbindungselement entsprechend stromführend sein kann. Beispielsweise ist das Verbindungselement eine Schraube oder eine Schraube in Verbindung mit einer Kontermutter oder ähnliches, dann ist die Aufnahme beispielsweise ein zylinderförmiger Hohlraum im Isoliergehäuse, welcher zu den Kontaktteilen hin ein Einführloch für das Verbindungselement aufweist und nach außen hin ein Zugangsloch z. B. für einen Schraubendreher, wobei das Zugangsloch einen geringeren Durchmesser aufweist als das Einführloch. Bei der Montage wird dann beispielsweise die Schraube in ein Schraubenloch zumindest eines der Kontaktteile eingesetzt und dann das Isoliergehäuse darüber angebracht, sodass die Schraube entsprechend verborgen ist. Durch das Zugangsloch ist die Schraube dann von außen betätigbar, indem ein entsprechendes Werkzeug eingeführt und mit dem Schraubenkopf in Eingriff gebracht wird. Das Zugangsloch stellt im verschraubten Zustand vorteilhaft einen Berührschutz sicher, d. h. der Durchmesser ist insbesondere derart bemessen, dass dieser kleiner ist als ein Prüffinger. Dies ist zwar vorteilhaft, an sich aber lediglich optional.

Die Kontaktteile liegen vorzugsweise aufeinander auf, bevorzugterweise jeweils endseitig. Dadurch ist je nach Form der Kontaktteile beim Übergang von dem einen Kontaktteil, welches oben liegt, zum anderen Kontaktteil, welches entsprechend unten liegt, insbesondere eine Stufe gebildet. Die oben beschriebene Aufnahme ist zweckmäßigerweise im Überlappbereich angeordnet, sodass das Verbindungselement entsprechend im Überlappbereich die beiden Kontaktteile verbindet und aneinander fixiert. Das ist aber an sich nicht zwingend. Vorzugsweise sind die Durchgangslöcher für ein jeweiliges Kontaktteil auf gegenüberliegenden Seiten der Aufnahme angeordnet, bevorzugterweise sogar spiegelsymmetrisch.

In einer besonders geeigneten Ausgestaltung weist das Isoliergehäuse zwei Flügel auf, welche sich jeweils seitlich an die Aufnahme anschließen und in welche die Durchgangslöcher eingebracht sind. Die Flügel schließen dabei in einer geeigneten Ausgestaltung einen Winkel von 180° ein, in einer anderen geeigneten Ausgestaltung einen anderen Winkel. Die Flügel sind beispielsweise jeweils als quaderförmige Wand ausgebildet, welche sich ausgehend von der Aufnahme von dieser fort erstreckt, insbesondere entlang eines der Kontaktteile. Im Falle einer ringförmigen Aufnahme wie oben beschrieben erstrecken sich die Flügel vorzugsweise jeweils in radialer Richtung und somit senkrecht zur Wand der Aufnahme. Ein jeweiliger Flügel ist zweckmäßigerweise 1,1-mal bis 5-mal so breit wie ein Durchgangsloch in diesem Flügel. Ein jeweiliger Flügel ist zweckmäßigerweise 1-mal bis 10-mal so lang wie breit. Ein jeweiliger Flügel ist zweckmäßigerweise 0,5-mal bis 5-mal so hoch wie lang. Andere Abmessungen sind aber ebenso grundsätzlich geeignet. Je nach Ausgestaltung der Durchgangslöcher im Flügel sind jedoch unter Umständen auch andere Abmessungen vorteilhaft. Wichtig ist insbesondere lediglich, dass ein jeweiliger Flügel eine hinreichende Wandstärke für die Durchgangslöcher zur Verfügung stellt und einen ausreichenden Berührschutz bietet.

Geeigneterweise ist das Isoliergehäuse zweiteilig ausgebildet, mit einem ersten Gehäuseteil für das eine Kontaktteil und mit einem zweiten Gehäuseteil für das andere Kontaktteil. Bei der Montage werden dann beide Gehäuseteile zunächst auf das jeweilige Kontaktteil aufgesetzt und dann werden die beiden Kontaktteile zusammengesetzt, wobei dann auch die Gehäuseteile zum Isoliergehäuse zusammengesetzt werden. Die beiden Gehäuseteile sind bevorzugterweise entsprechend komplementär zueinander ausgebildet, vorzugsweise derart, dass das Isoliergehäuse die Kontaktteile dann vollumfänglich umgibt. Dadurch ist die Montage einfach und zugleich ist ein guter Berührschutz ausgebildet. Grundsätzlich ist es aber auch denkbar und vorteilhaft, wenn das Isoliergehäuse lediglich einteilig, d. h. einstückig oder monolithisch, ausgebildet ist oder andersherum mehr als zwei Gehäuseteile aufweist.

Die Durchgangslöcher sind vorzugsweise in einem oder beiden der Gehäuseteile ausgebildet.

In einer zweckmäßigen Ausgestaltung sind sämtliche Durchgangslöcher in dem ersten Gehäuseteil ausgebildet, sodass das zweite Gehäuseteil entsprechend keine Durchgangslöcher aufweist und somit frei von Durchgangslöchern ist. Geeigneterweise weist dann das zweite Gehäuseteile aber eine Aussparung auf, welche von dem ersten Gehäuseteil derart überdeckt ist, dass zumindest eines der Durchgangslöcher in die Aussparung führt, sodass das entsprechende Kontaktteil mit einer Messelektrode kontaktierbar ist. Zumindest eines der Durchgangslöcher in dem ersten Gehäuseteil führt dann über die Aussparung im zweiten Gehäuseteil zum Kontaktteil im zweiten Gehäuseteil.

In einer ebenfalls zweckmäßigen Ausgestaltung ist eine erste Teilanzahl der Durchgangslöcher im ersten Gehäuseteil ausgebildet und eine zweite Teilanzahl der Durchgangslöcher ist im zweiten Gehäuseteil ausgebildet. Ein jeweiliges Durchgangsloch ist somit entweder im ersten oder im zweiten Gehäuseteil ausgebildet. Dies ermöglicht insbesondere eine Anordnung der Messelektroden derart, dass diese von unterschiedlichen, insbesondere gegenüberliegenden Seiten des Isoliergehäuses zugeführt werden, beispielsweise zwei Messelektroden von der einen Seite, z. B. von oben zu dem einen Kontaktteil, und die verbleibenden zwei Messelektroden von einer anderen Seite, z. B. von unten zu dem anderen Kontaktteil.

Besonders bevorzugt ist eine Ausgestaltung, bei welcher die Elektroverbindung eine Elektro-Schraubverbindung ist, indem das Verbindungselement eine Schraube mit einer Kontermutter ist, wobei die Schraube einen Schraubenkopf und ein Schaftende aufweist, welche auf gegenüberliegenden Seiten der beiden Kontaktteile angeordnet sind, wobei auf das Schaftende die Kontermutter aufgeschraubt ist. Ausgehend vom Schraubenkopf erstreckt sich ein Schraubenschaft, welcher bei der Montage durch entsprechende Schraubenlöcher in den Kontaktteilen hindurchgeführt wird, bis der Schraubenkopf auf einer Seite aufliegt, d. h. an eines der Kontaktteile anschlägt. Die Schraubenlöcher weisen nicht notwendigerweise ein Gewinde auf, sondern sind sogar vorzugsweise gewindefrei. Der Schraubenschaft weist endseitig ein Schaftende auf, welches dann auf der gegenüberliegenden Seite hervorsteht, sodass ein Innengewinde aufschraubbar ist, z. B. von einer Gewindehülse, einer Mutter oder einer Kontermutter, welche beispielsweise an oder in einem Gehäuse oder an einem der Kontaktteile befestigt ist, z. B. angeschweißt oder angeklebt. Bei der Montage wird die Kontermutter entsprechend auf das Schaftende aufgesetzt und die Schraube und die Kontermutter werden gegeneinander angezogen, sodass die Kontaktteile in montiertem Zustand dann zwischen dem Schraubenkopf und der Kontermutter eingeklemmt sind und somit das Verbindungselement insgesamt die beiden Kontaktteile aneinander befestigt.

Ein besonderer Vorteil der Durchgangslöcher ist insbesondere, dass die Messelektroden bereits während der Montage und beim Verbinden der Kontaktteile mittels des Verbindungselements in das Isoliergehäuse einführbar sind, sodass entsprechend Prozesszeit gespart wird. In einer geeigneten Ausgestaltung werden vor der Messung und während die Messelektroden in die Durchgangslöcher eingeführt werden das Verbindungselement betätigt und dadurch die beiden Kontaktteile miteinander verbunden. Hierbei wird vorteilhafterweise ein gemeinsames Werkzeug verwendet, welches ein Werkzeuggehäuse aufweist, in welchem sowohl die Messelektroden als auch ein Betätigungselement zum Betätigen des Verbindungselements angeordnet sind. Das Werkzeug ist demnach auch ein Messwerkzeug. Zweckmäßigerweise erstrecken sich die Durchgangslöcher und das Verbindungselement parallel zueinander, sodass das gesamte Werkzeug aus einer einzelnen Richtung an das Isoliergehäuse herangeführt wird. Dabei greift zum einen ein Betätigungselement für das Verbindungselement in dieses ein und zum anderen werden die Messelektroden parallel dazu in die Durchgangslöcher eingefahren. Geeigneterweise sind die Messelektroden oder das Betätigungselement oder beide federbelastet, um zugleich einen korrekten Eingriff und eine korrekte Kontaktierung zu gewährleisten. Das Betätigungselement ist beispielsweise eine Spindel, welche auf einer Seite in das Verbindungselement eingreift und auf einer anderen Seite angetrieben wird, um das Betätigungselement zu betätigen, z. B. wird die Spindel gedreht, um eine Schraube eines Verbindungselements einzuschrauben, d. h. in Verbindung mit einer Kontermutter anzuziehen. Zweckmäßigerweise weist die zuvor beschriebene Aufnahme des Isoliergehäuses - sofern vorhanden - eine Öffnung zum Einführen des Betätigungselements auf.

Die Messung wird insbesondere unmittelbar im Anschluss an die Montage der Elektroverbindung durchgeführt, d. h. nachdem die Kontaktteile mittels des Verbindungselements verbunden worden sind, da die Messelektroden bereits im Kontakt mit den Kontaktteilen sind. Der Erfolg der Montage ist dadurch direkt überprüfbar. Falls eines der Kontaktteile ein Teil einer Batterie ist, z. B. einer Hochvoltbatterie, ist das Werkzeug beim Einführen der Messelektroden zweckmäßigerweise von der Batterie galvanisch getrennt, sodass die Messelektroden zum Messen elektrisch sicher mit den Kontaktteilen kontaktierbar sind, da dann beide Kontaktteile aufgrund der Verbindung mittels des Verbindungselements auf einem annähernd gleichen elektrischen Potential liegen. Ein Unterschied zwischen den Potentialen ergibt sich lediglich insbesondere aufgrund eines Kontaktwiderstands. Im Ergebnis werden jedenfalls keine gefährlichen Potentialunterschiede, d. h. Spannungen, über die Messelektroden in das Werkzeug geleitet, welches somit entsprechend sicher bedienbar ist. Das Werkzeuggehäuse ist vorzugsweise nach außen hin isoliert und schützt die Messelektroden vor einer Berührung.

Nachfolgend werden Ausführungsbeispiele der Erfindung anhand einer Zeichnung näher erläutert. Darin zeigen jeweils schematisch:
- Fig. 1: eine Elektroverbindung und ein Werkzeug,
- Fig. 2: die Elektroverbindung aus Fig. 1 und eine Variante des Werkzeugs,
- Fig. 3: die Elektroverbindung und das Werkzeug aus Fig. 1 in einer anderen Ansicht,
- Fig. 4: die Elektroverbindung aus Fig. 1 in unmontiertem Zustand,
- Fig. 5: die Elektroverbindung aus Fig. 4 in einer anderen Ansicht,
- Fig. 6: ein Diagramm,
- Fig. 7: eine Variante der Elektroverbindung aus Fig. 1 in einer Draufsicht,
- Fig. 8: eine weitere Variante der Elektroverbindung aus Fig. 1 in einer Draufsicht,
- Fig. 9: eine Variante des Werkzeugs aus Fig. 1 im Zusammenhang mit der Elektroverbindung aus Fig. 8,
- Fig. 10: die Elektroverbindung aus Fig. 1 und ein Prüffinger,
- Fig. 11: die Elektroverbindung und der Prüffinger aus Fig. 10 in einer anderen Ansicht.

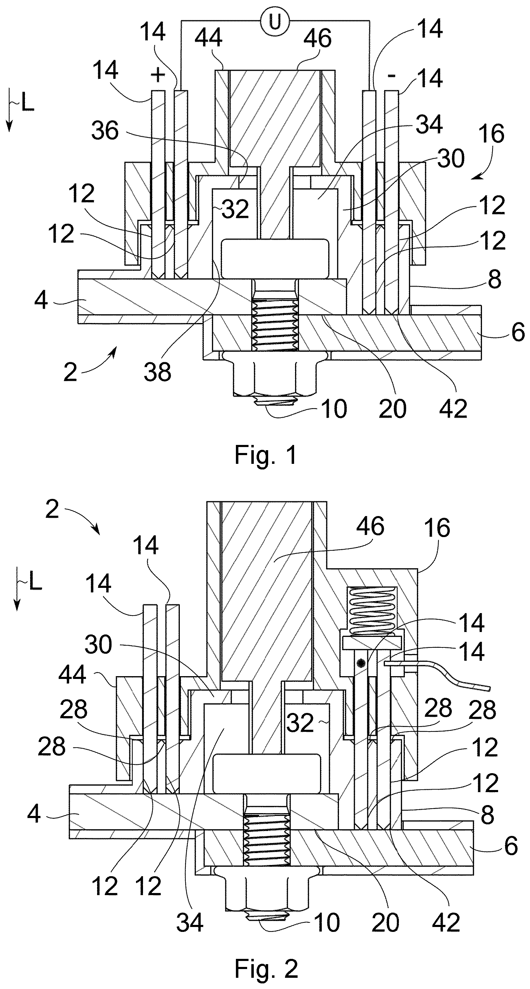

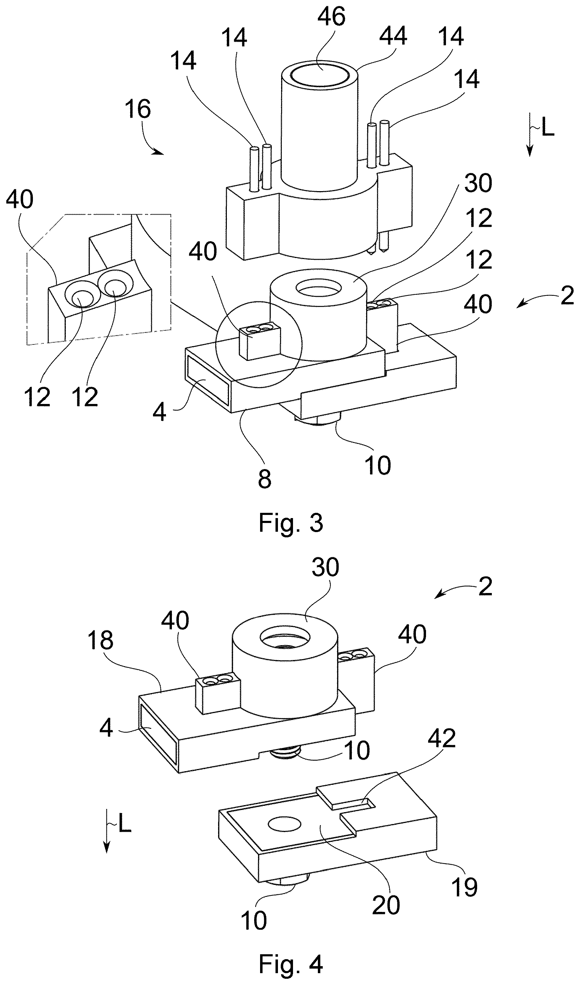

In Fig. 1 ist ein Ausführungsbeispiel einer Elektroverbindung 2 in einer Querschnittansicht entlang einer Längsrichtung L gezeigt. Die Elektroverbindung 2 weist zwei Kontaktteile 4, 6 auf, nämlich ein erstes Kontaktteil 4 und ein zweites Kontaktteil 6. Weiter weist die Elektroverbindung 2 ein Isoliergehäuse 8 und ein Verbindungselement 10 auf, welches hier eine Kombination aus einer Schraube 48 und einer Kontermutter 50 ist. Die beiden Kontaktteile 4, 6 sind mittels des Verbindungselements 10 derart miteinander verbunden, dass die beiden Kontaktteile 4, 6 aneinander anliegen und sind mittels des Verbindungselements 10 aneinandergedrückt. Das Isoliergehäuse 8 weist ein oder mehrere Durchgangslöcher 12 auf, zum Aufnehmen von Messelektroden 14 zur Bestimmung eines Übergangswiderstands zwischen den beiden Kontaktteilen 4, 6. Die Messelektroden 14 sind Teil eines Werkzeugs 16, für welches ein Ausführungsbeispiel ebenfalls in Fig. 1 gezeigt ist. Fig. 2 zeigt eine Variante des Werkzeugs 16, bei welchem zwei der Messelektroden 14 federbelastet sind. In Fig. 3 sind die Elektroverbindung 2 und das Werkzeug 16 aus Fig. 1 in einer perspektivischen Ansicht gezeigt.

In den hier gezeigten Ausführungsbeispielen sind lediglich Elektroverbindungen 2 mit nur zwei Kontaktteilen 4, 6 gezeigt, die Ausführungen gelten jedoch analog auch für Elektroverbindungen 2 mit mehr als zwei Kontaktteilen 4, 6.

Ein jeweiliges Durchgangsloch 12 stellt auf einfache Weise einen Zugang zu einem oder beiden Kontaktteilen 4, 6 dar, nämlich von außen durch das Isoliergehäuse 8 hindurch und hin zum Kontaktteil 4, 6. Zum Messen werden die Messelektroden 14 in die Durchgangslöcher 12 soweit eingefahren, bis wie in Fig. 1 und 2 erkennbar ein elektrischer Kontakt mit einem jeweiligen Kontaktteil 4, 6 hergestellt ist. Daraufhin wird gemessen. Anschließend werden die Messelektroden 14 auf umgekehrtem Wege wieder zurückgefahren. Ein jeweiliges Durchgangsloch 12 dient insgesamt als Führungskanal für eine oder mehrere Messelektroden 14.

Die beiden Kontaktteile 4, 6 sind über die Durchgangslöcher 12 für die Messelektroden 14 derart zugänglich, dass eine jeweilige Messelektrode 14 durch eines der Durchgangslöcher 12 in das Isoliergehäuse 8 einführbar ist und mit einem der beiden Kontaktteile 4, 6 kontaktierbar ist, um einen Spannungsabfall zwischen den beiden Kontaktteilen 4, 6 zu messen. Die Messung ist in Fig. 1 angedeutet. Somit werden zum Messen wenigsten zwei Messelektroden 14 verwendet, von welchen eine mit dem einen Kontaktteil 4 kontaktiert wird und die andere mit dem anderen Kontaktteil 6. Die Durchgangslöcher 12 sind entsprechend derart ausgebildet und angeordnet, dass beide Kontaktteile 4, 6 von außen für je mindestens eine Messelektrode 14 zugänglich sind. Die Messelektroden 14 sind hier als Messspitzen ausgebildet, welche wie in den Fig. 1 und 2 erkennbar auf eine Oberfläche des jeweiligen Kontaktteils 4, 6 gedrückt werden, um einen möglichst punktförmigen elektrischen Kontakt zum Messen herzustellen.

Die Kontaktteile 4, 6 sind bei bestimmungsgemäßer Verwendung der Elektroverbindung 2 regelmäßig stromführend und daher aus einem elektrisch leitenden Material hergestellt. In den gezeigten Ausführungsbeispielen sind die Kontaktteile 4, 6 jeweils als eine Stromschiene ausgebildet, d. h. flach und langgestreckt, und weisen somit jeweils eine nicht explizit bezeichnete Flachseite auf, welche zur Herstellung einer elektrischen Verbindung aneinander anliegen und mittels des Verbindungselements 10 aneinandergedrückt sind, wie besonders gut in den Fig. 1 und 2 erkennbar ist. In einer möglichen Ausgestaltung verbindet die Elektroverbindung 2 in einer Hochvoltbatterie ein Batteriemodul der Hochvoltbatterie mit einem Modulverbinder der Hochvoltbatterie. Das eine Kontaktteil 4, 6 ist dann ein Teil des Batteriemoduls, das andere Kontaktteil 4, 6 dagegen ein Teil des Modulverbinders. In einer weiteren möglichen Ausgestaltung verbindet die Elektroverbindung 2 in einer Hochvoltbatterie ein Batteriemodul der Hochvoltbatterie unmittelbar mit einem weiteren Batteriemodul, sodass das eine Kontaktteil 4, 6 dann Teil des Batteriemoduls ist und das andere Kontaktteil 4, 6 einen Modulverbinder ausbildet.

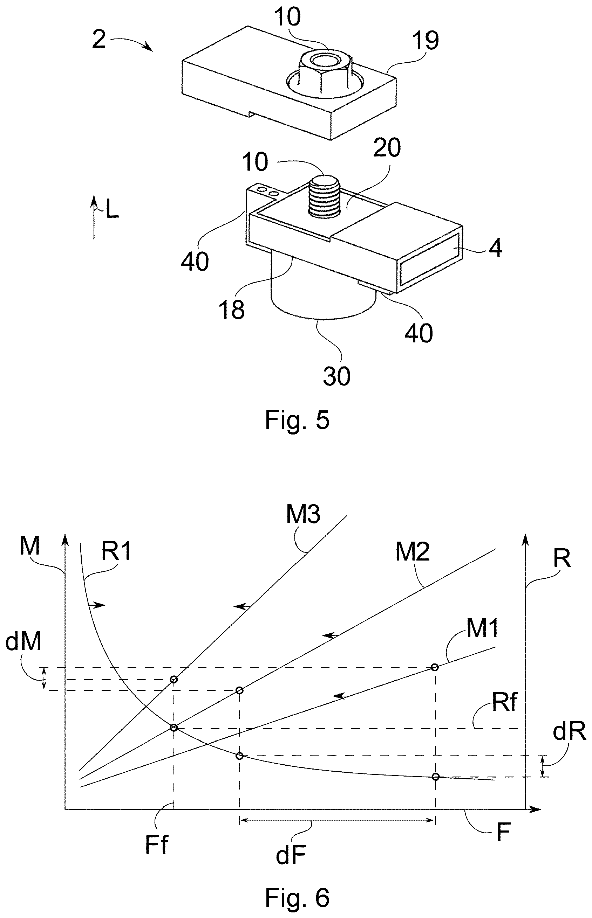

Das Isoliergehäuse 8 dient vorliegend auch als Berührschutz, d. h. als physische Barriere gegen ein Berühren der Kontaktteile 4, 6. Entsprechend überdeckt das Isoliergehäuse 8 wenigstens eines und hier beide Kontaktteile 4, 6 und umgibt und umschließt diese hier sogar. Dies ist speziell aus den Fig. 4 und 5 erkennbar, welche die Elektroverbindung 2 aus Fig. 1 in einer perspektivischen Ansicht zeigen und mit auseinandergezogenen Kontaktteilen 4, 6 und in einem unmontierten Zustand. Das Isoliergehäuse 8 weist hier zwei Gehäuseteile 18, 19 auf, je eines für ein jeweiliges Kontaktteil 4, 6. Das Isoliergehäuse 8 ist somit auf die beiden Kontaktteile 4, 6 aufgesetzt oder umgekehrt sind die beiden Kontaktteile 4, 6 in das Isoliergehäuse 8 eingesetzt oder eingesteckt. Das Isoliergehäuse 8 ist vorliegend aus einem elektrisch Isolierenden Material hergestellt.

Mittels der Durchgangslöcher 12 ist es nun möglich, nach dem Verbinden der beiden Kontaktteile 4, 6 den Übergangswiderstand R zwischen diesen zu bestimmen. Bei einem entsprechenden Verfahren werden dann bei der Elektroverbindung 2 mehrere Messelektroden 14 in die Durchgangslöcher 12 eingeführt und mit den Kontaktteilen 4, 6 in Kontakt gebracht und anschließend wird mittels der Messelektroden 14 eine Messung durchgeführt, anhand dessen der Übergangswiderstand R zwischen den beiden Kontaktteilen 4, 6 bestimmt wird. In den hier gezeigten Ausführungsbeispielen wird der Übergangswiderstand R dadurch bestimmt, dass ein Spannungsabfall beim Übergang von einem Kontaktteil 4 zum anderen Kontaktteil 6 gemessen wird, wie speziell in Fig. 1 verdeutlich ist. Genau genommen ist die Messung dann eine Spannungsmessung. Der Spannungsabfall erlaubt einen direkten Rückschluss auf den Übergangswiderstand R.

Grundsätzlich ist es möglich, bei der Montage der Elektroverbindung 2 ein definiertes Montagemoment M auf die Schraube 48 aufzubringen und zugleich einen Drehwinkel der Schraube 48 zu überwachen. Das Montagemoment M dient als Steuergröße, der Drehwinkel als Kontrollgröße. Soweit das Montagemoment M und der Drehwinkel innerhalb eines vorgegebenen Toleranzfensters liegen, wird die Verschraubung als korrekt klassifiziert, d. h. als fehlerfrei angenommen. Eine gute Elektroverbindung 2 zeichnet sich aber vor allem durch einen möglichst geringen Übergangswiderstand R zwischen den beiden Kontaktteilen 4, 6 aus. Speziell bei Elektroverbindungen 2 sollte der Übergangswiderstand R möglichst gering sein. Der Übergangswiderstand R (auch als Kontaktwiderstand bezeichnet) hängt typischerweise hauptsächlich von einer Vorspannkraft F (auch als Kontaktnormalkraft oder Montagevorspannkraft bezeichnet) ab, mit welcher die beiden Kontaktteile 4, 6 beim Verbinden aneinandergedrückt werden.

Das Montagemoment M und der Drehwinkel sind aber hinsichtlich des Übergangswiderstands R lediglich indirekte Größen und lassen daher einen nur unzureichenden Schluss auf den Übergangswiderstand R nach der Montage zu. Ob die Verschraubung für die vorgesehene elektrische Verwendung korrekt ist, kann nicht unbedingt sicher beurteilt werden. Beispielsweise können das Montagemoment M und der Drehwinkel zwar im geforderten Toleranzfenster liegen, dennoch kann sich bei einem zu hohen Reibwert von möglicherweise fehlerhaften Kontaktteilen 4, 6 oder einer fehlerhaften Schraube 48 eine unzureichende Vorspannkraft F ergeben. Dies ist in Fig. 6 anhand eines Diagramms verdeutlicht, welches auf der Horizontalachse die Vorspannkraft F zeigt, auf der linken Vertikalachse das Montagemoment M und auf der rechten Vertikalachse den Übergangswiderstand R. Die Funktionen M1, M2, M3 zeigen das Montagemoment M als Funktion der Vorspannkraft F für drei verschiedene Reibwerte, wobei für höhere Reibwerte die Steigung zunimmt. Die Funktion R1 zeigt den Übergangswiderstand R als Funktion der Vorspannkraft F. Deutlich erkennbar ist, dass mit steigender Vorspannkraft F das Montagemoment M zunimmt und der Übergangswiderstand R abnimmt. Wie aus Fig. 6 erkennbar ist, ergeben sich bei unterschiedlichem Reibwert für dasselbe Montagemoment M unterschiedliche Vorspannkräfte F. Ist beispielsweise durch die beiden Funktionen M1, M2 ein Toleranzfenster dM für das Montagemoment M definiert und analog auch je ein Toleranzfenster dF, dR für die Vorspannkraft F und den Übergangswiderstand R, dann ist erkennbar, dass bei höherem Reibwert die dritte Funktion M3 zwar immer noch ein Montagemoment M innerhalb des Toleranzfensters dM ergibt, dass aber die Vorspannkraft F und der Übergangswiderstand R jeweils inakzeptable Werte annehmen. Außerdem ist erkennbar, dass ein Montagemoment M im Toleranzfenster dM bei höherem Reibwert gemäß der Funktion M3 eine zu niedrige Vorspannkraft Ff und damit einen zu hohen Übergangswiderstand Rf erzeugt. Das Montagemoment M ist demnach allein nicht geeignet, um die Qualität der Verbindung zu bewerten und zu entscheiden, ob die Elektroverbindung 2 korrekt ist. Der Übergangswiderstand R, welche vorliegend über den Spannungsabfall direkt als eine Kontrollgröße zugänglich ist, erlaubt dann entsprechend direkt die Qualität der elektrischen Verbindung zwischen den beiden Kontaktteilen 4, 6 zu beurteilen, sodass insgesamt eine bessere Beurteilung der Elektroverbindung 2 möglich ist.

Nach der Messung des Spannungsabfalls und der Bestimmung des Übergangswiderstands R und nachdem die Messelektroden 14 wieder entfernt worden sind, sind die Durchgangslöcher 12 vorliegend funktionslos. Nach der Montage und während des bestimmungsgemäßen Gebrauchs der Elektroverbindung 2 verbleiben die Durchgangslöcher 12 somit lediglich als charakteristische, visuelle Merkmale des Isoliergehäuses 8. Die Durchgangslöcher 12 verbleiben in den gezeigten Ausführungsbeispielen offen, in einer nicht gezeigten Ausgestaltung werden die Durchgangslöcher 12 dagegen jeweils mit einem Verschlusselement verschlossen. In einer anderen Ausgestaltung wird der Übergangswiderstand R z. B. im Rahmen einer Wartung erneut bestimmt, wozu dann durch die Durchgangslöcher 12 erneut entsprechende Messelektroden 14 eingefahren werden.

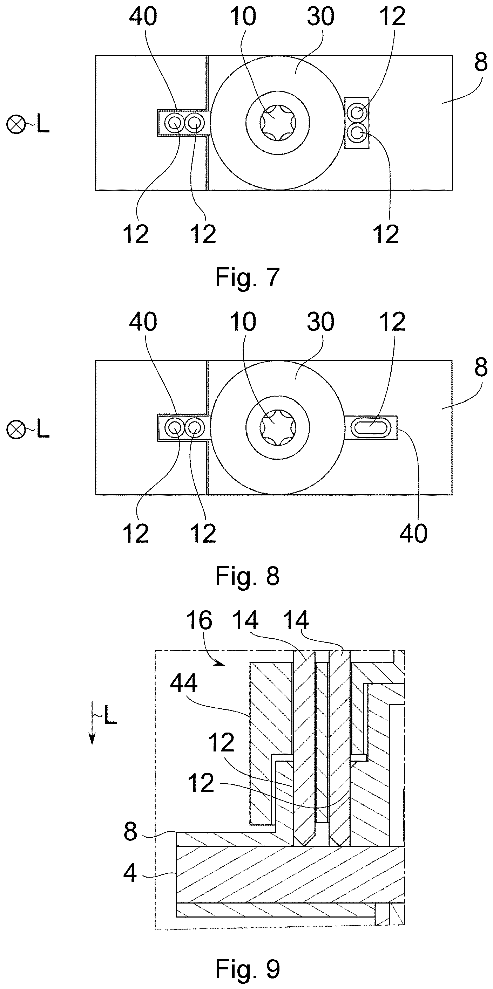

Vorliegend ist das Isoliergehäuse 8 für eine Vierpunktmessung mit vier Messelektroden 14 ausgebildet, nämlich je zwei Messelektroden 14 pro Kontaktteil 4, 6. Die Messung ist demnach eine Vierpunktmessung. Dabei werden zunächst vier Messelektroden 14 mit den Kontaktteilen 4, 6 in Kontakt gebracht. Über zwei der Messelektroden 14, auch als Stromführungselektroden bezeichnet, wird ein Strom durch die beiden Kontaktteile 4, 6 geschickt und mit den beiden anderen Messelektroden 14, auch als Spannungsmesselektroden bezeichnet, wird dann eine Spannungsmessung durchgeführt. Ein jeweiliges Kontaktteil 4, 6 ist also mit einer Stromführungselektrode und einer Spannungsmesselektrode kontaktiert. In den Ausführungsbeispielen der Fig. 1 und 2 sind die Messelektroden 14 in einer Reihe auf die Kontaktteile 4, 6 gebracht, sodass zwei Messelektroden 14 innen liegen und die anderen zwei Messelektroden 14 außen liegen. Bei einer solchen Anordnung der Messelektroden 14 in einer Reihe fließt dann wie in Fig. 1 gezeigt zwischen den äußeren beiden Messelektroden 14 ein Strom und die Spannungsmessung erfolgt mit den inneren beiden Messelektroden 14. Eine solche Anordnung ist jedoch an sich nicht zwingend, da im vorliegenden Fall der Übergangswiderstand R nicht notwendigerweise absolut bestimmt werden muss, sondern eine relative Messung bereits ausreichend ist. Dies ermöglicht eine beliebige Anordnung der Messelektroden 14 und der Durchgangslöcher 12, beispielsweise wie in Fig. 7 gezeigt. Fig. 7 zeigt eine Variante der Elektroverbindung 2 in einer Draufsicht in Längsrichtung L. Deutlich erkennbar ist, dass die vier Durchgangslöcher 12 nicht in einer Reihe angeordnet sind, sondern dass die beiden Durchgangslöcher 12 auf der rechten Seite übereinander angeordnet sind und nicht nebeneinander wie die beiden Durchgangslöcher auf der linken Seite oder die Durchgangslöcher in den Fig. 1 und 2. Abseits von der Anordnung in Fig. 7 sind auch andere Anordnung der Durchgangslöcher 12 möglich, wie beispielsweise eine Anordnung der Durchgangslöcher 12 sowohl auf dem ersten Gehäuseteil 18 als auch auf dem zweiten Gehäuseteil 19, wobei die Durchgangslöcher 12 nicht zwingend auf einer gleichen Seite der Gehäuseteile 18, 19 angeordnet sind. D. h., dass mindestens das eine Durchgangsloch 12 auf einer Seite der Elektroverbindung 2 und das mindestens andere Durchgangloch 12 auf einer dem einen Durchgangsloch 12 gegenüberliegenden Seite, ausgehend davon, dass die senkrechte Achse zur Längsrichtung L, eine Symmetrieachse ist, angeordnet ist.

Vorliegend sind die Durchgangslöcher 12 auch derart positioniert, dass die Messelektroden 14 bei der Messung die Kontaktteile 4, 6 außerhalb eines Überlappbereichs 20 der Kontaktteile 4, 6 kontaktieren. Der Überlappbereich ist besonders gut erkennbar in den Fig. 4 und 5 aber auch in Fig. 1 und 2. Die beiden Kontaktteile 4, 6 liegen zumindest abschnittsweise aneinander an, um einen elektrischen Kontakt herzustellen. Der Überlappbereich 20 ist dann derjenige Bereich, in welchem die beiden Kontaktteile 4, 6 überlappen, genauer gesagt in Längsrichtung L betrachtet überlappen, und aneinander anliegen, um sich gegenseitig zu berühren.

In den Ausführungsbeispielen der Fig. 1 bis 5 und 7 weist das Isoliergehäuse 8 für jede Messelektrode 14 genau ein Durchgangsloch 12 auf. Bei vier Messelektroden 14 für eine Vierpunktmessung weist das Isoliergehäuse 8 entsprechend vier Durchgangslöcher 12 auf. Ein jeweiliges Durchgangsloch 12 weist hier zudem einen Querschnitt auf, welcher einem Querschnitt einer jeweiligen Messelektrode 14 entspricht. Die Messelektroden 14 sind hier stabförmig und laufen frontseitig zum Kontaktteil 4, 6 hin spitz zu, sodass sich allgemein ein kreisrunder Querschnitt ergibt und entsprechend auch die Durchgangslöcher 12 dann jeweils einen kreisrunden Querschnitt aufweisen, sodass in seitlicher Richtung, d. h. senkrecht zur Längsrichtung L, ein Formschluss realisiert ist.

Wie die in Fig. 8 gezeigte Variante der Elektroverbindung 2 verdeutlicht, muss die Anzahl der Durchgangslöcher 12 aber nicht zwingend der Anzahl der Messelektroden 14 entsprechen, vielmehr sind auch Ausgestaltungen möglich, bei welchen zumindest ein Durchgangsloch 12 ausgebildet ist, mehrere Messelektroden 14 gleichzeitig aufzunehmen. In Fig. 8 ist wie in Fig. 7 eine Elektroverbindung 2 in einer Draufsicht gezeigt. Zumindest ein Durchgangsloch 12, hier auf der rechten Seite, ist als ein Langloch ausgebildet, zur gleichzeitigen Aufnahme mehrerer Messelektroden 14 nebeneinander. In Fig. 9 ist ausschnittsweise und in einer Querschnittansicht gezeigt, wie in einem einzelnen Durchgangsloch 12 mit mehrere Messelektroden 14 gemessen wird. Im gezeigten Ausführungsbeispiel ist zwischen den zwei Messelektroden 14, welche in dasselbe Durchgangloch 12 eingefahren werden, eine Isolierwand 22 angeordnet, welche ein Teil des Werkzeugs 16 ist. Abseits der gezeigten Ausgestaltungen sind auch weitere Ausgestaltungen denkbar und geeignet, bei welchen ein einzelnes Durchgangsloch 12 mehrere Messelektroden 14 für unterschiedliche Kontaktteile 4, 6 aufnimmt oder bei welcher sogar lediglich ein einzelnes Durchgangsloch 12 sämtliche Messelektroden 14 aufnimmt.

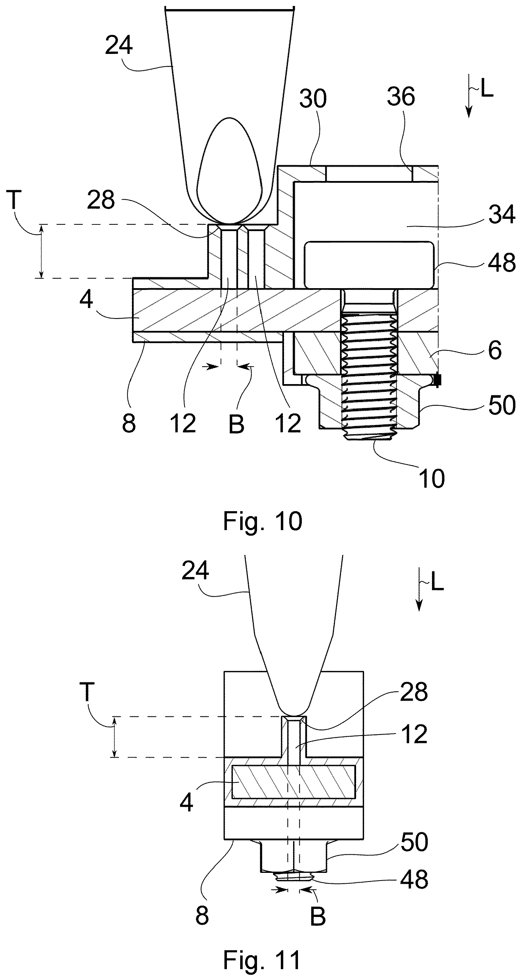

Wie bereits angedeutet, dient das Isoliergehäuse 8 zugleich als Berührschutz. Die Durchgangslöcher 12 ermöglichen jedoch prinzipiell einen Zugang zu den Kontaktteilen 4, 6. Daher ist ein jeweiliges Durchgangsloch 12 vorliegend derart dimensioniert, dass eine Berührung eines Kontaktteils 4, 6 mit einem Prüffinger 24 durch das jeweilige Durchgangsloch 12 hindurch verhindert ist. Dies ist in Fig. 10 für die Elektroverbindung 2 aus Fig. 1 in der gleichen Ansicht wir in Fig. 1 gezeigt und in Fig. 11 für dieselbe Elektroverbindung 2 in einer hierzu um 90° um die Längsachse L gedrehten Querschnittansicht. Die Durchganglöcher 12 sind derart dimensioniert, dass ein Schutz gemäß der IP-Schutzklasse IPxxB realisiert ist und hierzu möglichst tief und möglichst schmal ausgebildet. Ein jeweiliges Durchgangsloch 12 weist speziell eine Breite B und eine Tiefe T auf, sodass ein genormter Prüffinger 24 nicht bis zum Kontaktteil 4, 6 vordringen kann. Zudem wird hier nicht nur eine Berührung verhindert, sondern bereits ein Vordringen bis zu einer Luftstrecke und/oder Kriechstrecke 26, welche angibt, in welchem Abstand zum Kontaktteil 4, 6 noch ein Überschlag vom Kontaktteil 4, 6 aus möglich ist. Insgesamt ergibt sich ein tunnelartiger Verlauf des entsprechend lang ausgebildeten Durchgangslochs 12, welcher auch zur Führung der Messelektrode 14 beim Einfahren dient.

In den gezeigten Ausführungsbeispielen weist ein jeweiliges Durchgangsloch 12 außenseitig, d. h. auf einer dem Kontaktteil 4, 6 abgewandten Außenseite des Isoliergehäuses 8, eine Führungsfase 28 auf, um das Einführen einer Messelektrode 14 zu vereinfachen. Außerdem werden in den gezeigten Ausführungsbeispielen alle Messelektroden 14 von derselben Seite zugeführt, sodass entsprechend auch sämtlich Durchgangslöcher 12 dann auf derselben Seite des Isoliergehäuses 8 ausgebildet sind. Auch verlaufen in den gezeigten Ausführungsbeispielen die Durchgangslöcher 12 senkrecht zu den Kontaktteilen 4, 6 durch das Isoliergehäuse 8 und zusätzlich parallel zum Verbindungselement 10, sodass ein Betätigen des Verbindungselements 10 und ein Einführen der Messelektroden 14 von derselben Seite und in einem einzelnen Montageschritt möglich ist, wie auch in den Fig. 1 bis 3 erkennbar ist. In den gezeigten Ausführungsbeispielen verlaufen alle Durchgangslöcher 12 auch parallel zueinander durch das Isoliergehäuse 8.

In den gezeigten Ausführungsbeispielen weist das Isoliergehäuse 8 für das Verbindungselement 10 eine Aufnahme 30 auf, in welche das Verbindungselement 10 bei der Montage der Elektroverbindung 2 einsetzbar ist, um die Kontaktteile 4, 6 miteinander zu verbinden. Die Aufnahme 30 erstreckt sich vorliegend in einer Längsrichtung L und hier auch senkrecht zu den Kontaktteilen 4, 6. Das Verbindungselement 10 erstreckt sich ebenfalls in Längsrichtung L. Die Aufnahme 30 ist vorliegend analog zu den Durchgangslöchern 12 derart dimensioniert, dass eine Berührung eines Kontaktteils 4, 6 mit einem genormten Prüffinger 24 durch das jeweilige Durchgangsloch 12 hindurch verhindert ist. Die Ausführungen hierzu im Zusammenhang mit den Durchgangslöchern 12 gelten entsprechend auch für die Aufnahme 30.

Die Aufnahme 30 ist vorliegend ringförmig ausgebildet und weist eine ringförmige Wand 32 auf, welche einen zylinderförmigen Hohlraum 34 umringt, in welchen das Verbindungselement 10 einsetzbar ist und in welchem zumindest in einem montierten Zustand das Verbindungselement 10 eingesetzt ist, wie beispielsweise in Fig. 1 erkennbar ist. In den gezeigten Ausgestaltungen ist die Aufnahme 30 eine Kammer, mit einem Zugangsloch 36, durch welches das Werkzeug 16 zur Betätigung des Verbindungselements 10 bei der Montage in die Kammer einführbar ist, nicht aber das Verbindungselement 10 selbst. Im Querschnitt entlang der Längsrichtung L betrachtet wird das Verbindungselement 10 dann von dem Isoliergehäuse 8 überdacht, wie z. B. in Fig. 1 erkennbar ist. Die Aufnahme 30 ist hier ein zylinderförmiger Hohlraum 34 im Isoliergehäuse 8, welcher zu den Kontaktteilen 4, 6 hin ein Einführloch 38 für das Verbindungselement 10 aufweist und nach außen hin das Zugangsloch 36, welches einen geringeren Durchmesser aufweist als das Einführloch 38. Durch das Zugangsloch 36 ist das Verbindungselement 10 von außen betätigbar, indem entsprechend, z. B. wie in den Fig. 1 und 2 gezeigt, ein Werkzeug 16 eingeführt und mit dem Verbindungselement 10 in Eingriff gebracht wird. Das Zugangsloch 36 stellt hier einen Berührschutz sicher, d. h. die Schraube kann im montierten Zustand nicht berührt werden.

Die Kontaktteile 4, 6 liegen in den gezeigten Ausführungsbeispiel aufeinander auf, vorliegend sogar jeweils endseitig. Dadurch ist hier beim Übergang von dem einen Kontaktteil 4, welches oben liegt, zum anderen Kontaktteil 6, welches entsprechend unten liegt, eine Stufe gebildet, welche besonders gut in den Fig. 1, 2 und 10 erkennbar ist. Die Aufnahme 30 ist im Überlappbereich 20 angeordnet, sodass das Verbindungselement 10 entsprechend im Überlappbereich 20 die beiden Kontaktteile 4, 6 verbindet und aneinander fixiert.

In den gezeigten Ausführungsbeispielen sind die Durchgangslöcher 12 für ein jeweiliges Kontaktteil 4, 6 auf gegenüberliegenden Seiten der Aufnahme 30 angeordnet, in den Fig. 1 bis 5 und 10 sogar spiegelsymmetrisch, in den Fig. 7 und 8 dagegen nicht spiegelsymmetrisch aber weiterhin auf gegenüberliegenden Seiten der Aufnahme 30.

In den gezeigten Ausführungsbeispielen weist das Isoliergehäuse 8 zwei Flügel 40 auf, welche sich jeweils seitlich an die Aufnahme 30 anschließen und in welche die Durchgangslöcher 12 eingebracht sind. Die Flügel 40 schließen dabei vorliegend einen Winkel von 180° ein, dieser Wert ist aber nicht zwingend und andere Winkel sind auch grundsätzlich geeignet. Die Flügel 40 sind hier lediglich beispielhaft jeweils als quaderförmige Wand ausgebildet, welche sich ausgehend von der Aufnahme 30 von dieser fort erstreckt, vorliegend entlang eines der Kontaktteile 4, 6. In Verbindung mit der ringförmigen Aufnahme 30 erstrecken sich die Flügel 40 jeweils in radialer Richtung und somit senkrecht zur Wand 32 der Aufnahme 30.Je nach Ausgestaltung der Durchgangslöcher 12 im Flügel 40 sind unterschiedliche Abmessungen der Flügel 40 denkbar und geeignet. In Fig. 7 ist nur ein Flügel 40 ausgebildet, die beiden Durchgangslöcher 12 auf der rechten Seite der Aufnahme 30 sind dagegen einfach in eine Wand eingebracht, welche hier zwar die gleichen Abmessungen aufweist wie der Flügel 40 auf der gegenüberliegenden Seite der Aufnahme 30, bezüglich diesem jedoch um 90° um die Längsachse L gedreht ist.

Das hier jeweils gezeigte Isoliergehäuse 8 ist wie bereits erwähnt zweiteilig ausgebildet, mit einem ersten Gehäuseteil 18 für das eine Kontaktteil 4 und mit einem zweiten Gehäuseteil 19 für das andere Kontaktteil 6. Die Gehäuseteile 18, 19 sind vorliegend keine Gleichteile. Bei der Montage werden beide Gehäuseteile 18, 19 zunächst auf das jeweilige Kontaktteil 4, 6 aufgesetzt, z. B. wie in den Fig. 4 und 5 erkennbar, und dann werden die beiden Kontaktteile 4, 6 zusammengesetzt, hier in Längsrichtung L, wobei dann auch die Gehäuseteile 18, 19 zum Isoliergehäuse 8 zusammengesetzt werden. Die beiden Gehäuseteile 18, 19 sind entsprechend komplementär zueinander ausgebildet, sodass das Isoliergehäuse 8 die Kontaktteile 4, 6 vollumfänglich umgibt. In einer nicht gezeigten Ausgestaltung ist das Isoliergehäuse 8 dagegen lediglich einteilig, d. h. einstückig oder monolithisch, ausgebildet oder weist sogar mehr als zwei Gehäuseteile 18, 19 auf.

In den gezeigten Ausgestaltungen sind sämtliche Durchganglöcher 12 in dem ersten Gehäuseteil 18 ausgebildet, sodass das zweite Gehäuseteil 19 entsprechend keine Durchgangslöcher 12 aufweist und somit frei von Durchgangslöchern 12 ist. Das zweite Gehäuseteile 19 weist aber eine Aussparung 42 auf, welche besonders gut in Fig. 4 erkennbar ist und welche von dem ersten Gehäuseteil 18 derart überdeckt ist, dass zumindest eines der Durchgangslöcher 12 in die 42 Aussparung führt, sodass das entsprechende Kontaktteil 4, 6 mit einer Messelektrode 14 kontaktierbar ist, wie in den Fig. 1 bis 3 erkennbar ist. Dort führen zwei der Durchgangslöcher 12 in dem ersten Gehäuseteil 18 über die Aussparung 42 im zweiten Gehäuseteil 19 zum Kontaktteil 6 im zweiten Gehäuseteil 19.

In den hier gezeigten Ausführungsbeispielen ist die Elektroverbindung 2 eine Elektro-Schraubverbindung, indem das Verbindungselement 10 eine Schraube 48 mit einer Kontermutter 50 ist, wobei die Schraube 48 einen Schraubenkopf und ein Schaftende aufweist, welche auf gegenüberliegenden Seiten der beiden Kontaktteile 4, 6 angeordnet sind, wobei auf das Schaftende die Kontermutter aufgeschraubt ist. Ausgehend vom Schraubenkopf erstreckt sich ein Schraubenschaft, welcher bei der Montage durch entsprechende Schraubenlöcher in den Kontaktteilen 4, 6 hindurchgeführt wird, bis der Schraubenkopf auf einer Seite aufliegt, d. h. an eines der Kontaktteile 4, 6 anschlägt. Die Schraubenlöcher weisen nicht notwendigerweise ein Gewinde auf, sondern sind vorliegend gewindefrei, da das Verbindungselement 10 zusätzlich zur Schraube 48 eine Kontermutter 50 aufweist. Der Schraubenschaft weist endseitig ein Schaftende auf, welches dann auf der gegenüberliegenden Seite hervorsteht, sodass die Kontermutter 50 oder allgemein ein Innengewinde aufschraubbar ist, wobei im gezeigten Ausführungsbeispiel die Kontermutter 50 befestigt ist und die Schraube 48 gedreht wird. Bei der Montage wird die Kontermutter 50 entsprechend auf das Schaftende aufgesetzt und die Schraube 48 und die Kontermutter 50 werden gegeneinander angezogen, sodass die Kontaktteile 4, 6 in montiertem Zustand dann zwischen dem Schraubenkopf und der Kontermutter 50 eingeklemmt sind und das Verbindungselement 10 die Kontaktteile 4, 6 aneinander befestigt.

Aufgrund der speziellen Durchgangslöcher 12 sind die Messelektroden 14 bereits während der Montage und beim Verbinden der Kontaktteile 4, 6 mittels des Verbindungselements 10 in das Isoliergehäuse 8 einführbar. Wie in den Fig. 1 und 2 erkennbar ist, werden vor der Messung und während die Messelektroden 14 in die Durchgangslöcher 12 eingeführt werden das Verbindungselement 10 betätigt und dadurch die beiden Kontaktteile 4, 6 miteinander verbunden. Hierbei wird das gemeinsame Werkzeug 16 verwendet, welches ein Werkzeuggehäuse 44 aufweist, in welchem sowohl die Messelektroden 14 als auch ein Betätigungselement 46 zum Betätigen des Verbindungselements 10 angeordnet sind. Das Werkzeug 16 ist demnach auch ein Messwerkzeug. Die Durchgangslöcher 12 und das Verbindungselement 10 erstrecken sich parallel zueinander, sodass das gesamte Werkzeug 16 aus einer einzelnen Richtung, hier der Längsrichtung L, an das Isoliergehäuse 8 herangeführt wird, z. B. wie in Fig. 3 gezeigt. Dabei greift zum einen das Betätigungselement 46 für das Verbindungselement 10 in dieses ein und zum anderen werden die Messelektroden 14 parallel dazu in die Durchgangslöcher 12 eingefahren. Im Ausführungsbeispiel der Fig. 2 sind die Messelektroden 14 federbelastet, alternativ oder zusätzlich ist das Betätigungselement 46 federbelastet. Das Betätigungselement 46 ist vorliegend eine Spindel, welche auf einer Seite in das Verbindungselement 10 eingreift und auf einer anderen Seite angetrieben wird, um das Betätigungselement 46 zu betätigen, d. h. im vorliegenden Fall wird die Spindel gedreht, um die Schraube 48 in Verbindung mit der Kontermutter anzuziehen, d. h. festzuziehen.

Die Messung wird dann im vorliegenden Fall unmittelbar im Anschluss an die Montage der Elektroverbindung 2 durchgeführt, d. h. nachdem die Kontaktteile 4, 6 mittels des Verbindungselements 10 verbunden worden sind, da die Messelektroden 14 nun bereits im Kontakt mit den Kontaktteilen 4, 6 sind. Der Erfolg der Montage wird dadurch direkt überprüft. Das Werkzeuggehäuse 44 ist dabei hier nach außen hin isoliert und schützt die Messelektroden 14 vor einer Berührung.

### Bezugszeichenliste

- 2: Elektroverbindung
- 4: erstes Kontaktteil
- 6: zweites Kontaktteil
- 8: Isoliergehäuse
- 10: Verbindungselement
- 12: Durchgangsloch
- 14: Messelektrode
- 16: Werkzeug
- 18: erstes Gehäuseteil
- 19: zweites Gehäuseteil
- 20: Überlappbereich
- 22: Isolierwand
- 24: genormter Prüffinger
- 26: Luftstrecke und/oder Kriechstrecke
- 28: Führungsfase
- 30: Aufnahme
- 32: Wand
- 34: Hohlraum
- 36: Zugangsloch
- 38: Einführloch
- 40: Flügel
- 42: Aussparung
- 44: Werkzeuggehäuse
- 46: Betätigungselement
- 48: Schraube
- 50: Kontermutter
- B: Breite
- dF: Toleranzfenster (Vorspannkraft)
- dM: Toleranzfenster (Montagemoment)
- dR: Toleranzfenster (Übergangswiderstand)
- F: Vorspannkraft
- Ff: zu niedrige Vorspannkraft
- L: Längsrichtung
- M: Montagemoment
- M1, M2, M3: Funktion
- R: Übergangswiderstand
- Rf: zu hoher Übergangswiderstand
- R1: Funktion
- T: Tiefe

## Patentansprüche

1. Elektroverbindung (2), welche mindestens zwei Kontaktteile (4, 6), ein Isoliergehäuse (8) und ein Verbindungselement (10) aufweist,
a. wobei die beiden Kontaktteile (4, 6) mittels des Verbindungselements (10) miteinander verbunden sind,
b. wobei das Isoliergehäuse (8) ein oder mehrere Durchgangslöcher (12) aufweist, zum Aufnehmen von Messelektroden (14) zur Bestimmung eines Übergangswiderstands (R) zwischen den beiden Kontaktteilen (4, 6),
**dadurch gekennzeichnet,**
**dass** das Isoliergehäuse (8) für eine Vierpunktmessung mit vier Messelektroden (14) ausgebildet ist, nämlich je zwei Messelektroden (14) pro Kontaktteil (4, 6).

2. Elektroverbindung (2) nach Anspruch 1,
wobei die beiden Kontaktteile (4, 6) über die Durchgangslöcher (12) für die Messelektroden (14) derart zugänglich sind, dass eine jeweilige Messelektrode (14) durch eines der Durchgangslöcher (12) in das Isoliergehäuse (8) einführbar ist und mit einem der beiden Kontaktteile (4, 6) kontaktierbar ist, um einen Spannungsabfall zwischen den beiden Kontaktteilen (4, 6) zu messen.

3. Elektroverbindung (2) nach einem der Ansprüche 1 bis 2,
wobei das Isoliergehäuse (8) für jede Messelektrode (14) genau ein Durchgangsloch (12) aufweist.

4. Elektroverbindung (2) nach einem der Ansprüche 1 bis 2,
wobei zumindest ein Durchgangsloch (12) als ein Langloch ausgebildet ist, zur gleichzeitigen Aufnahme mehrerer Messelektroden (14).

5. Elektroverbindung (2) nach einem der Ansprüche 1 bis 4,
wobei ein jeweiliges Durchgangsloch (12) derart dimensioniert ist, dass eine Berührung eines Kontaktteils (4, 6) mit einem Prüffinger (24) durch das jeweilige Durchgangsloch (12) hindurch verhindert ist.

6. Elektroverbindung (2) nach einem der Ansprüche 1 bis 5,
wobei die Durchgangslöcher (12) senkrecht zu den Kontaktteilen (4, 6) durch das Isoliergehäuse (8) verlaufen oder parallel zum Verbindungselement (10) oder beides.

7. Elektroverbindung (2) nach einem der Ansprüche 1 bis 6,
wobei das Isoliergehäuse (8) für das Verbindungselement (10) eine Aufnahme (30) aufweist, in welche das Verbindungselement (10) bei einer Montage der Elektroverbindung (2) einsetzbar ist.

8. Elektroverbindung (2) nach Anspruch 7,
wobei das Isoliergehäuse (8) zwei Flügel (40) aufweist, welche sich jeweils seitlich an die Aufnahme (30) anschließen und in welche die Durchgangslöcher (12) eingebracht sind.

9. Elektroverbindung (2) nach einem der Ansprüche 1 bis 8,
wobei das Isoliergehäuse (8) zweiteilig ausgebildet ist, mit einem ersten Gehäuseteil (18) für das eine Kontaktteil (4) und mit einem zweiten Gehäuseteil (19) für das andere Kontaktteil (6).

10. Elektroverbindung (2) nach einem der Ansprüche 1 bis 9,
wobei diese eine Elektro-Schraubverbindung ist, indem das Verbindungselement (10) eine Schraube (48) mit einer Kontermutter (50) ist,
wobei die Schraube (48) einen Schraubenkopf und ein Schaftende aufweist, welche auf gegenüberliegenden Seiten der beiden Kontaktteile (4, 6) angeordnet sind,
wobei auf das Schaftende die Kontermutter (50) aufgeschraubt ist.

11. Verfahren
wobei bei einer Elektroverbindung (2) gemäß einem der Ansprüche 1 bis 10 vier Messelektroden (14) in die Durchganglöcher (12) eingeführt werden und mit den Kontaktteilen (4, 6) in Kontakt gebracht werden, wobei anschließend mittels der Messelektroden (14) eine Messung durchgeführt wird, anhand dessen der Übergangswiderstand (R) zwischen den beiden Kontaktteilen (4, 6) bestimmt wird.

12. Verfahren nach Anspruch 11,
wobei vor der Messung und während die Messelektroden (14) in die Durchgangslöcher (12) eingeführt werden das Verbindungselement (10) betätigt wird und dadurch die beiden Kontaktteile (4, 6) miteinander verbunden werden.

13. Werkzeug angepasst an ein Verfahren gemäß Anspruch 12, welches ein Werkzeuggehäuse (44) aufweist, in welchem sowohl die Messelektroden (14) als auch ein Betätigungselement (46) zum Betätigen des Verbindungselements (10) angeordnet sind.

## Claims

1. An electrical connection (2) which has at least two contact parts (4, 6), an insulating housing (8) and a connection element (10),
a. wherein both contact parts (4, 6) are connected to each other by means of the connecting element (10),
b. wherein the insulating housing (8) comprises one or more through holes (12), for receiving measuring electrodes (14) for determining a contact resistance (R) between both contact parts (4, 6),
**characterized in that**
the insulating housing (8) is configured for four-point measurement with four measuring electrodes (14), namely two measuring electrodes (14) for each contact part (4, 6).

2. The electrical connection (2) according to claim 1,
wherein both contact parts (4, 6) are accessible for the measuring electrodes (14) via the through holes (12) in such a way that a respective measuring electrode (14) can be introduced through one of the through holes (12) into the insulating housing (8) and can be brought into contact with one of both contact parts (4, 6), in order to measure a voltage drop between both contact parts (4, 6).

3. The electrical connection (2) according to any one of claims 1 to 2,
wherein the insulating housing (8) has exactly one through hole (12) for each measuring electrode (14).

4. The electrical connection (2) according to any one of claims 1 to 2,
wherein at least one through hole (12) is configured as an oblong hole, for the simultaneous reception of several measuring electrodes (14).

5. The electrical connection (2) according to any one of claims 1 to 4,
wherein a respective through hole (12) is dimensioned such to prevent contact of a contact part (4, 6) with a test finger (24) through the respective through hole (12).

6. The electrical connection (2) according to any one of claims 1 to 5,
wherein the through holes (12) extend perpendicular to the contact parts (4, 6) through the insulating housing (8) or parallel to the connecting element (10) or both.

7. The electrical connection (2) according to any one of claims 1 to 6,
wherein the insulating housing (8) comprises a receptacle (30) for the connecting element (10) into which the connecting element (10) can be inserted during assembly of the electrical connection (2).

8. The electrical connection (2) according to claim 7,
wherein the insulating housing (8) has two wings (40) which each connect laterally to the housing (30) and in which the through holes (12) are provided.

9. The electrical connection (2) according to any one of claims 1 to 8,
wherein the insulating housing (8) is configured as two parts, with a first housing part (18) for one of the contact parts (4) and with a second housing part (19) for the other contact part (6)

10. The electrical connection (2) according to any one of claims 1 to 9,
wherein this is a threaded electrical connection, by the fact that the connecting element (10) is a screw (48) with a lock nut (50),
wherein the screw (48) has a screw head and a rod end, which are arranged on opposite sides of both contact parts (4, 6),
wherein the lock nut (50) is screwed onto the rod end.

11. A method in which, in an electrical connection (2) according to any one of claims 1 to 10, four measuring electrodes (14) are introduced into the through holes (12) and brought into contact with the contact parts (4, 6), wherein subsequently a measurement is carried out by means of the measuring electrodes (14), with the aid of which the contact resistance (R) between both contact parts (4, 6) is determined.

12. The method according to claim 11,
wherein, before the measurement and while the measuring electrodes (14) are inserted into the through holes (12), the connecting element (10) is actuated and both contact parts (4, 6) are thus connected to each other.

13. A tool, adapted to a method according to claim 12,
which comprises a tool housing (44), in which both the measuring electrodes (14) and also an actuating element (46) for actuating the connecting element (10) are arranged.

## Revendications

1. Raccordement électrique (2) qui comporte au moins deux parties de contact (4, 6), un boîtier isolant (8) et un élément de raccordement (10),
a. les deux parties de contact (4, 6) étant reliées l'une à l'autre au moyen de l'élément de raccordement (10),
b. le boîtier isolant (8) comportant un ou plusieurs trous traversants (12), pour la réception d'électrodes de mesure (14) destinées à la détermination d'une résistance de contact (R) entre les deux parties de contact (4, 6),
**caractérisé en ce que**
le boîtier isolant (8) est configuré pour une mesure en quatre points avec quatre électrodes de mesure (14), à savoir deux électrodes de mesure (14) pour chaque partie de contact (4, 6).

2. Raccordement électrique (2) selon la revendication 1,
dans lequel les deux parties de contact (4, 6) sont accessibles pour les électrodes de mesure (14) via les trous traversants (12) de façon telle qu'une électrode de mesure (14) respective peut être introduite dans le boîtier isolant (8) à travers l'un des trous traversants (12) et peut être mise en contact avec l'une des deux parties de contact (4, 6), afin de mesurer une baisse de tension entre les deux parties de contact (4, 6).

3. Raccordement électrique (2) selon l'une quelconque des revendications 1 à 2, dans lequel le boîtier isolant (8) comporte exactement un trou traversant (12) pour chaque électrode de mesure (14).

4. Raccordement électrique (2) selon l'une quelconque des revendications 1 à 2, dans lequel au moins un trou traversant (12) est configuré sous forme d'un trou oblong, pour la réception simultanée de plusieurs électrodes de mesure (14).

5. Raccordement électrique (2) selon l'une quelconque des revendications 1 à 4,
dans lequel un trou traversant (12) respectif est dimensionné de manière à empêcher un contact d'une partie de contact (4, 6) avec un doigt de test (24) à travers le trou traversant (12) respectif.

6. Raccordement électrique (2) selon l'une quelconque des revendications 1 à 5, dans lequel les trous traversants (12) s'étendent perpendiculairement aux parties de contact (4, 6) à travers le boîtier isolant (8) ou parallèlement à l'élément de raccordement (10) ou les deux.

7. Raccordement électrique (2) selon l'une quelconque des revendications 1 à 6, dans lequel le boîtier isolant (8) comporte pour l'élément de raccordement (10) un logement (30) dans lequel l'élément de raccordement (10) peut être inséré lors d'un montage du raccordement électrique (2).

8. Raccordement électrique (2) selon la revendication 7,
dans lequel le boîtier isolant (8) comporte deux ailes (40) qui se raccordent chacune latéralement au logement (30) et dans lesquelles sont ménagés les trous traversants (12).

9. Raccordement électrique (2) selon l'une quelconque des revendications 1 à 8, dans lequel le boîtier isolant (8) est configuré en deux parties, avec une première partie (18) de boîtier pour l'une des parties de contact (4) et avec une seconde partie (19) de boîtier pour l'autre partie de contact (6)

10. Raccordement électrique (2) selon l'une quelconque des revendications 1 à 9, celui-ci étant un raccordement électrique fileté, par le fait que l'élément de raccordement (10) est une vis(48) avec un contre-écrou (50),
la vis (48) présentant une tête de vis et une extrémité de tige qui sont disposées sur des côtés opposés des deux parties de contact (4, 6),
le contre-écrou (50) étant vissé sur l'extrémité de tige.

11. Procédé dans lequel, dans un raccordement électrique (2) selon l'une quelconque des revendications 1 à 10 quatre électrodes de mesure (14) sont introduites dans les trous traversants (12) et mises en contact avec les parties de contact (4, 6), une mesure étant ensuite effectuée au moyen des électrodes de mesure (14), à l'aide de laquelle est déterminée la résistance de contact (R) entre les deux parties de contact (4, 6)

12. Procédé selon la revendication 11,
dans lequel avant la mesure et pendant que les électrodes de mesure (14) sont introduites dans les trous traversants (12), l'élément de raccordement (10) est actionné et les deux parties de contact (4, 6) sont ainsi raccordées l'une à l'autre.

13. Outil adapté à un procédé selon la revendication 12,
qui comporte un boîtier (44) d'outil, dans lequel sont disposés aussi bien les électrodes de mesure (14) qu'un élément d'actionnement (46) destiné à l'actionnement de l'élément de raccordement (10).
